# EUROPÄISCHE PATENTSCHRIFT

(11) **EP 0 852 056 B1**
(45) Veröffentlichungstag und Bekanntmachung des Hinweises auf die Patenterteilung: **16.06.1999**
(21) Anmeldenummer: 96934423.3
(22) Anmeldetag: 16.09.1996
(51) Int. Cl.: G11C 11/40

(54) **SRAM-SPEICHERZELLE**
SRAM STORAGE CELL
CELLULE DE MEMOIRE RAM STATIQUE

(30) Priorität: 21.09.1995 DE 19535106
(43) Veröffentlichungstag der Anmeldung: 08.07.1998
(73) Patentinhaber: SIEMENS AKTIENGESELLSCHAFT, 80333 München (DE)
(72) Erfinder: GOSSNER, Harald, Dr., D-81735 München (DE); EISELE, Ignaz, Prof., D-82057 Icking (DE); WITTMANN, Franz, Dr., D-81737 München (DE); RAMGOPAL RAO, Valipe, D-80337 München (DE)
(86) Internationale Anmeldenummer: DE9601745
(87) Internationale Veröffentlichungsnummer: WO9711465

(56) Entgegenhaltungen:
- EP-A- 0 073 167
- EP-A- 0 337 870
- IEEE TRANSACTIONS ON ELECTRON DEVICES, Bd. 39, Nr. 6, 1.Juni 1992, Seiten 1398-1409, XP000271788 REISCH M: "ON BISTABLE BEHAVIOR AND OPEN-BASE BREAKDOWN OF BIPOLAR TRANSISTORS IN THE AVALANCHE REGIME-MODELING AND APPLICATIONS"
- IEEE JOURNAL OF SOLID-STATE CIRCUITS, JUNE 1994, USA, Bd. 29, Nr. 6, ISSN 0018-9200, Seiten 733-736, XP002026009 SHULMAN D D: "A static memory cell based on the negative resistance of the gate terminal of p-n-p-n devices"
- PROCEEDINGS OF 1994 IEEE INTERNATIONAL ELECTRON DEVICES MEETING, SAN FRANCISCO, CA, USA, 11-14 DEC. 1994, ISBN 0-7803-2111-1, 1994, NEW YORK, NY, USA, IEEE, USA, Seiten 381-384, XP000585514 CARNS T K ET AL: "A novel high speed, high density SRAM cell utilizing a bistable GeSi/Si tunnel diode"

## Beschreibung

Die Erfindung betrifft eine SRAM-Speicherzelle.

Es sind Speicherzellen statischer Speicher mit wahlfreiem Zugriff (SRAMs) bekannt bei denen ein Flip-Flop zum Speichern von Potentialwerten dient, die logische Zustände darstellen. Dabei ist das Flipflop aus vier Feldeffekttransistoren aufgebaut. Die Speicherzelle weist außerdem zwei Auswahltransistoren auf, die zum Ein- und Auslesen der Speicherzelle dienen, deren Gates mit einer Wortleitung des SRAMs verbunden sind und die das Flip-Flop mit einem Bitleitungspaar verbinden. Insgesamt handelt es sich also um eine 6-Transistor-Speicherzelle. Es ist auch bekannt, das Flip-Flop mit zwei Feldeffekttransistoren und zwei Widerständen zu realisieren, so daß sich eine 4-Transistor-Speicherzelle ergibt.

Der Erfindung liegt die Aufgabe zugrunde, eine SRAM-Speicherzelle zu schaffen, die einen geringen Flächenbedarf hat.

Diese Aufgabe wird durch eine SRAM-Speicherzelle gemäß Anspruch 1 gelöst. Bei dieser dient ein bistabiler Feldeffekttransistor anstelle eines Flipflops zum Speichern von zwei logischen Zuständen. Der eine logische Zustand entspricht dem gesperrten, der andere logische Zustand dem geöffneten bistabilen Transistor.

Unter einem bistabilen Feldeffekttransistor soll hier ein Transistor verstanden werden, der eine hysteretische Strom-Gatespannungs-Kennlinie aufweist , so daß er nur durch Anlegen einer geeigneten positiven bzw. einer geeigneten negativen Schwellenspannung vom Sperrzustand in den Hochstromzustand und umgekehrt wechselt. Gatespannungswerte zwischen den Werten der beiden Schwellenspannungen bewirken keinen Zustandswechsel. Ein bistabiler Transistor ist also beispielsweise mit Spannungsimpulsen steuerbar, die nur kurzzeitig die jeweilige (positive oder negative) Schwellenspannung betragsmäßig überschreiten.

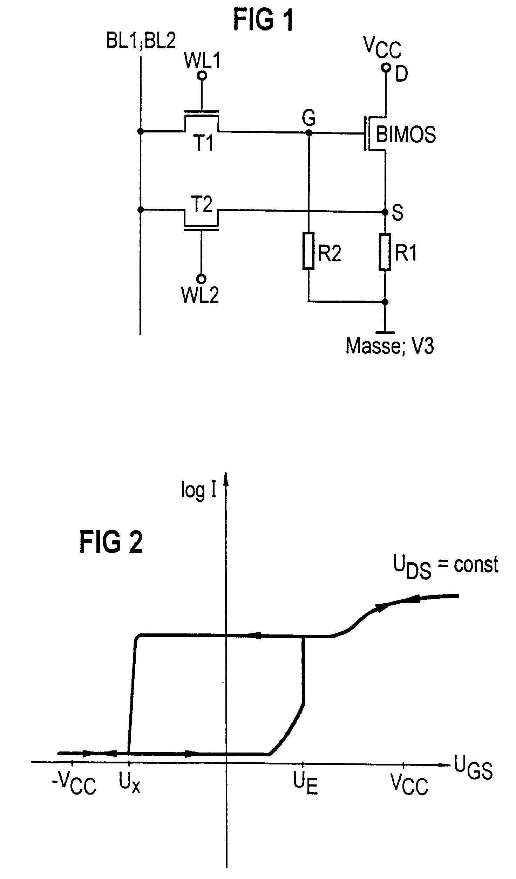

Figur 2 stellt den Verlauf der erwähnten Hysteresefunktion eines bistabilen Feldeffekttransistors dar, wobei die Drain-Source-Spannung U_{DS} als konstant und großer als ein bestimmter Minimalwert angenommen wird, bei dem das hysteretische Verhalten einsetzt, und der während des Betriebs des bistabilen Transistors nicht unterschritten werden sollte. Auf der Abszisse ist die Gate-Source-Spannung U_{GS} und auf der Ordinate der logarithmierte Drainstrom I abgetragen. Die positive Schwellenspannung ist mit U_{E} bezeichnet.

Aus N. Kistler, E.V. Ploeg, J. Woo und J. Plummer "Breakdown Voltage of Submicron MOSFETs in Fully Depleted SOI" in Microelectronic Manufacturing and Reliability, Volume 1802 (1992), Seiten 202ff. ist ein Feldeffekttransistor bekannt, der sich erfindungsgemäß als bistabiler Feldeffekttransistor einsetzen läßt. Dort wird ein vollständig depletierter (das heißt im nichtleitenden Zustand sind in seinem Kanalgebiet praktisch keine freien Ladungsträger vorhanden) lateraler n-Kanal-Feldeffekttransistor beschrieben, der in SOI-(Silicon on Insulator-)Technik ausgeführt ist. Sein Kanalgebiet floated, ist also mit keinem festen Potential verbunden.

Oft ist das Substrat, auf dem der bistabile Transistor angeordnet ist, mit einem Substratpotential verbunden. Dann ist es erforderlich, um ein Floaten des Kanalgebiets zu erreichen, daß dieses vom Substrat isoliert ist. Beim genannten Stand der Technik geschieht dies durch Anwendung der SOI-Technik. Der bistabile Transistor kann aber auch, anders als beim genannten Stand der Technik, vertikal auf einem Halbleitersubstrat angeordnet sein, so daß sein Kanalgebiet auf einfache Weise vom Substrat isoliert ist. Ein solcher vertikaler bistabiler Transistor kann z.B. mit Molekularstrahl-Epitaxie hergestellt werden. Es lassen sich auf diese Weise Kanallängen von wenigen zehn Nanometern erreichen. In Versuchen wurde festgestellt, daß sich eine Kanallänge von kleiner als 100 nm, beispielsweise 85 nm, besonders gut zur Herstellung eines vertikalen bistabilen Transistors eignet.

Wichtig für die Herstellung eines bistabilen Transistors ist es, daß sein Kanalgebiet im Sperrzustand depletiert ist. Im Hochstromzustand, d.h. bei Anliegen einer die positive Schwellenspannung überschreitenden Gatespannung, kommt es dann zu einem Durchbruch des Transistors, wobei durch Stoßionisation Ladungsträger freigesetzt werden. Bei Kanallängen, die größer als 1 µm sind, ist eine ausreichende Depletierung durch Verwendung eines wenig durch Dotierstoffe verunreinigten Kanalgebietes erreichbar. Kürzere Kanallängen erlauben Kanalgebiete mit höheren Dotierstoffkonzentrationen. Die Depletierung läßt sich insbesondere durch die Ausweitung der Sperrschicht des gesperrten pn-Übergangs bei angelegter Drain-Source-Spannung erreichen. Bei den kurzen Kanallängen ergibt sich auch bei niedrigen Drain-Source-Spannungen (z.B. <3V) eine hinreichend hohe elektrische Feldstärke, die für den Durchbruch im Hochstromzustand erforderlich ist.

Der beschriebene Hystereseeffekt wirkt sich folgendermaßen aus: Befindet sich die Drain-Source-Spannung des bistabilen Feldeffekttransistors oberhalb des schon erwähnten Minimalwertes, der durch die verwendete Technologie und die Abmessungen des Transistors bestimmt ist, kann der bistabile Feldeffekttransistor durch Erhöhen seiner Gate-Source-Spannung auf Werte oberhalb einer ebenfalls einstellbaren positiven Schwellenspannung von einem Sperrzustand in einen leitenden bzw. Hochstromzustand versetzt werden. In diesem Hochstromzustand bleibt er auch dann, wenn die Gate-Source-Spannung wieder auf Werte unterhalb der positiven Schwellenspannung abgesenkt wird, sofern der Minimalwert der Drain-Source-Spannung nicht unterschritten wird. Erst bei Anlegen einer ausreichend negativen Gate-Source-Spannung, bei der eine negative Schwellenspannung unterschritten wird, sperrt der Transistor wieder. (Diese Erläuterungen beziehen sich auf bistabile Transistoren vom n-Kanal-Typ. Bei p-Kanal-Transistoren gilt jedoch Entsprechendes).

Die erfindungsgemäße Speicherzelle funktioniert nach folgendem Prinzip, wobei das hysteretische Verhalten des bistabilen Feldeffekttransistors ausgenutzt wird: Zum Einschreiben eines ersten logischen Wertes, z.B. einer logischen Eins, wird der bistabile Transistor durch Anlegen eines geeigneten Gatepotentials (bei dem die positive Schwellenspannung der Gate-Source-Spannung überschritten wird) mittels einer ersten Bitleitung in seinen Hochstromzustand versetzt. Dieser wird beibehalten, auch wenn die Gate-Source-Spannung wieder Werte unterhalb der positiven Schwellenspannung annimmt. Ein zweiter logischer Wert, z.B. eine logische Null, wird eingeschrieben, indem durch Anlegen einer ausreichend negativen Gate-Source-Spannung (und unterschreiten der negativen Schwellenspannung) der bistabile Transistor von seinem Hochstromzustand in den Sperrzustand versetzt wird. Der bistabile Transistor ist also durch Spannungsimpulse steuerbar.

Das Auslesen der Speicherzelle erfolgt, indem der zweite Kanalanschluß mit einer zweiten Bitleitung verbunden wird. Diese wird dann entsprechend dem Zustand des bistabilen Transistors entweder auf den Wert des ersten oder den des zweiten Potentials geladen.

Da erfindungsgemäß statt eines Flipflops beim Stand der Technik, welches vier Transistoren oder zwei Transistoren und zwei Widerstände aufweist, nur ein einziger bistabiler Feldeffekttransistor und ein Widerstand zum Speichern eingesetzt werden, kann gegenüber den bekannten Lösungen wenigstens ein Transistor und ein Widerstand eingespart werden, wodurch sich ein geringerer Flächenbedarf der Speicherzelle ergibt.

Wird zum Einschreiben in die und zum Auslesen aus der Speicherzelle jeweils ein erster und ein zweiter Feldeffekttransistor vorgesehen, ergibt sich mit dem bistabilen Feldeffekttransistor eine 3-Transistor-Speicherzelle anstelle der bekannten 6- bzw. 4-Transistor-Speicherzellen.

Günstig ist es, wenn die erste Bitleitung mit der zweiten Bitleitung übereinstimmt, also nur eine Bitleitung vorhanden ist. Über diese erfolgt dann sowohl das Einschreiben in die als auch das Auslesen aus der Speicherzelle. Die erfindungsgemäße Speicherzelle kann also entweder zwei Bitleitungen und eine einzige Wortleitung zur Steuerung des ersten und des zweiten Transistors oder nur eine einzige Bitleitung und jeweils eine Wortleitung zur Steuerung des ersten und des zweiten Transistors aufweisen. Natürlich ist es auch möglich, daß je zwei Bit- und zwei Wortleitungen vorhanden sind.

Vorteilhaft ist es, wenn das Gate des bistabilen Transistors über einen zweiten Widerstand mit einem dritten Potential verbindbar ist, welches dafür sorgt, daß er zu keinem Zeitpunkt ein undefiniertes Potential aufweist. Es wird dann eine geringere Fehleranfälligkeit der Speicherzelle erreicht.

Die Erfindung wird im folgenden mittels der Zeichnung anhand von Ausführungsbeispielen näher erläutert. Es zeigen:
- Figur 1: eine Ausführungsform der erfindungsgemäßen Speicherzelle,
- Figur 2: die hysteresebehaftete Kennlinie des bistabilen Feldeffekttransistors aus Figur 1.

Figur 1 zeigt einen bistabilen Feldeffekttransistor BIMOS, dessen erster Kanalanschluß D mit einem Anschluß für ein erstes Potential VCC verbunden ist und dessen zweiter Kanalanschluß S über einen ersten Widerstand R1 mit einem Anschluß für ein zweites Potential Masse verbunden ist.

Bei diesem Ausführungsbeispiel der Erfindung ist der bistabile Feldeffekttransistor BIMOS vom n-Kanal-Typ. Es ist angenommen, daß das erste Potential VCC größer als das zweite Potential Masse ist. Beispielsweise können beide Potentiale VCC, Masse Versorgungspotentiale einer integrierten Schaltung sein, deren Bestandteil die SRAM-Speicherzelle ist. Das zweite Potential Masse kann dann beispielsweise ein Bezugspotential sein. Da angenommenermaßen das erste Potential VCC größer als das zweite Potential Masse ist, ist bei diesem Ausführungsbeispiel der erste Kanalanschluß D des bistabilen Feldeffekttransistors BIMOS dessen Drain und der zweite Kanalanschluß S seine Source.

Es ist selbstverständlich auch möglich, eine Speicherzelle mit einem bistabilen Feldeffekttransistor BIMOS vom p-Kanal-Typ aufzubauen, bei welchem das erste Potential VCC dann kleiner als das zweite Potential Masse zu wählen ist.

Das Gate G des bistabilen Feldeffekttransistors BIMOS in Figur 1 ist über einen ersten Feldeffekttransistor T1, der bei diesem Ausführungsbeispiel vom n-Kanal-Typ ist, mit einer ersten Bitleitung BL1 verbunden. Der erste Feldeffekttransistor T1 ist über eine erste Wortleitung WL1 steuerbar, die mit seinem Gate verbunden ist.

Der zweite Kanalanschluß S des bistabilen Feldeffekttransistors BIMOS ist über einen zweiten Feldeffekttransistor T2 mit einer zweiten Bitleitung BL2 verbindbar, die bei diesem Ausführungsbeispiel mit der ersten Bitleitung BL1 identisch ist. Der zweite Feldeffekttransistor T2 ist über eine zweite Wortleitung WL2 steuerbar, die mit seinem Gate verbunden ist.

Der erste T1 und der zweite T2 Transistor können auch vom p-Kanal-Typ sein, so daß für ihre Ansteuerung die Potentiale der beiden Wortleitungen WL1, WL2 entsprechend zu ändern sind.

Am Gate G des bistabilen Feldeffekttransistors BIMOS liegt bei geöffnetem ersten T1 und zweiten T2 Transistor über einen zweiten Widerstand R2 ein drittes Potential V3 an, welches bei diesem Ausführungsbeispiel gleich dem zweiten Potential Masse ist. Über den zweiten Widerstand R2 wird dafür gesorgt, daß das Gate G zu keinem Zeitpunkt floated, das heißt niemals ein undefiniertes Potential aufweist. Der Wert des dritten Potentials V3 sollte so gewählt sein, daß bei geöffnetem ersten T1 und zweiten T2 Transistor die Gate-Source-Spannung U_{GS} des bistabilen Transistors BIMOS nicht größer als seine positive Schwellenspannung U_{E} und nicht kleiner als die negative Schwellenspannung Uₓ ist, bei der ein Wechsel vom Hochstrom- in den Sperrzustand erfolgt (siehe Figur 2). Der zweite Widerstand R2 kann auch entfallen, jedoch kann dann die Speicherzelle aufgrund des dann floatenden Gates G Fehlfunktionen unterworfen sein.

Die in Figur 1 dargestellte Speicherzelle funktioniert in folgender Weise:

### 1.) Einschreiben in die Speicherzelle:

Das Potential am zweiten Kanalanschluß S kann, wie im folgenden noch erläutert wird, zwei Werte annehmen: Einerseits den Wert des ersten Potentials VCC abzüglich mindestens des oben bereits beschriebenen Minimalwertes der Drain-Source-Spannung U_{DS}, der zur Aufrechterhaltung des Hochstromzustandes erforderlich ist. Andererseits den Wert des zweiten Potentials Masse. Welchen der beiden Werte es annimmt, hängt davon ab, ob sich der bistabile Transistor BIMOS im Sperr- oder im Hochstromzustand befindet. Dabei entspricht der Hochstromzustand des bistabilen Transistors BIMOS beispielsweise einer gespeicherten logischen Eins und der Sperrzustand einer gespeicherten logischen Null.

Über die zweite Wortleitung WL2 sei der zweite Feldeffekttransistor T2 gesperrt. Beim dargestellten Ausführungsbeispiel geschieht dies, indem die zweite Wortleitung WL2 ein Potential aufweist, welches invers zum ersten Potential VCC ist, also den gleichen Betrag wie dieses, jedoch ein umgekehrtes Vorzeichen aufweist. Es soll angenommen werden, daß sich der bistabile Feldeffekttransistor BIMOS zu Beginn in seinem Sperrzustand befindet (d.h., in der Speicherzelle ist z.B. eine logische Null gespeichert). Sowohl an seinem Gate G als auch an seinem zweiten Kanalanschluß S liegt dann über den zweiten R2 bzw. ersten R1 Widerstand das zweite Potential Masse an.

Wird nun der erste Feldeffekttransistor T1 durch Ladung der ersten Wortleitung WL1 auf den Wert des ersten Potentials VCC geöffnet (Hochstromzuständ), kann ein neuer Speicherwert (beispielsweise eine logische Eins) in die Speicherzelle eingeschrieben werden. Hierzu erfolgt vor dem Öffnen des ersten Transistors T1 eine Ladung der ersten Bitleitung BL1 auf ein Potential (das beispielsweise gleich dem ersten Potential VCC sein kann), das nach dem Herstellen der Verbindung mit dem Gate G des bistabilen Transistors BIMOS dieses auflädt, so daß die positive Schwellenspannung U_{E} des bistabilen Transistors BIMOS überschritten wird.

Aufgrund der charakteristischen Eigenschaften des bistabilen Feldeffekttransistors BIMOS bleibt dieser im Hochstromzustand, also leitend, auch wenn der erste Feldeffekttransistor T1 wieder geschlossen wird und am Gate G des bistabilen Feldeffekttransistors BIMOS über den zweiten Widerstand R2 erneut das zweite Potential Masse anliegt. Wichtig ist nur, daß im Hochstromzustand die Drain-Source-Spannung U_{DS} niemals unter den besagten Minimalwert absinkt. Dies kann durch entsprechende Dimensionierung des bistabilen Transistors BIMOS und des ersten Widerstandes R1 erreicht werden.

Ein erneuter Wechsel des gespeicherten logischen Zustandes ist nur möglich, wenn der bistabile Feldeffekttransistor BIMOS wieder gesperrt wird. Dies geschieht, indem die erste Bitleitung BL1 auf ein negatives Potential gebracht wird, welches unterhalb der negativen Hystereseschwelle Uₓ des bistabilen Feldeffekttransistors BIMOS liegt. Wird dann der erste Feldeffekttransistor T1 geöffnet, entspricht das Potential des Gates G des bistabilen Feldeffekttransistors BIMOS nahezu demjenigen auf der Bitleitung BL. Der bistabile Feldeffekttransistor BIMOS sperrt, und über den ersten Widerstand R1 liegt wieder das zweite Potential Masse am zweiten Kanalanschluß S an.

### 2.) Auslesen der Speicherzelle:

Der erste Feldeffekttransistor T1 sei gesperrt. Das Auslesen geschieht über den zweiten Feldeffekttransistor T2. Wird dieser geöffnet, wird die zweite Bitleitung BL2 auf das Potential am zweiten Kanalanschluß S geladen. Es ist dabei günstig, wenn vor dem Öffnen des zweiten Feldeffekttransistors T2 die zweite Bitleitung BL2 auf den Wert des zweiten Potentials Masse vorgeladen wird. Liegt am zweiten Kanalanschluß S nämlich das zweite Potential Masse an (der bistabile Transistor BIMOS ist gesperrt), so muß kein Umladen der zweiten Bitleitung BL2 über den hochohmigen ersten Widerstand R1 stattfinden. Liegt dagegen am zweiten Kanalanschluß S das erste Potential VCC abzüglich der Drain-Source-Spannung des bistabilen Transistors BIMOS an (dieser ist dann geöffnet), so wird die zweite Bitleitung BL2 über den bistabilen Feldeffekttransistor BIMOS und den zweiten Feldeffekttransistor T2 geladen. Hierdurch sinkt zwar das Potential am zweiten Kanalanschluß S kurzzeitig geringfügig ab, jedoch wird dadurch der bistabile Feldeffekttransistor BIMOS noch weiter geöffnet (denn seine Drain-Source-Spannung U_{DS} wächst dadurch an), so daß die Umladung der zweiten Bitleitung BL2 noch beschleunigt wird.

Bei geeigneter Dimensionierung (Wert des ersten Widerstandes R1 im Teraohmbereich) weist die Speicherzelle auch bei geöffnetem bistabilen Transistor BIMOS einen nur geringen Ruhestrom auf (dann ist der zweite Feldeffekttransistor T2 gesperrt und es wird nicht ausgelesen), während andererseits beim Auslesen der Speicherzelle ein hoher Ladestrom für die Bitleitung BL erzielbar ist, der über den bistabilen Transistor BIMOS geliefert wird. Die zweite Bitleitung BL2 ist, wie oben beschrieben, auf den Wert des zweiten Potentials Masse vorladbar, so daß niemals ein Ladestrom über den ersten Widerstand R1 fließt. Der Widerstand R1 muß so demensioniert sein, daß die Spannung zwischen dem ersten VCC und dem zweiten Masse Potential im Sperrzustand im wesentlichen über dem sperrenden bistabilen Transistor BIMOS abfällt, so daß am zweiten Kanalanschluß S nahezu das zweite Potential Masse anliegt. Im Hochstromzustand dagegen soll am zweiten Kanalanschluß S die Differenz aus dem ersten Potential VCC und dem Minimalwert der Drain-Source-Spannung anliegen.

Durch das Auslesen über den zweiten Transistor T2 bleibt der Speicherzustand der Speicherzelle, also der Zustand des bistabilen Transistors BIMOS (Sperr- oder Hochstromzustand) unverändert. Eine Änderung des Speicherzustands kann nur über den ersten Feldeffekttransistor T1 und die erste Bitleitung BL1 erzielt werden.

Damit bei geöffnetem ersten Transistor T1 nur ein niedriger Strom zwischen dem Gate G des bistabilen Feldeffekttransistor BIMOS und dem zweiten Potential Masse fließt, ist auch der zweite Widerstand R2 möglichst hochohmig zu wählen.

Die Erfindung stellt eine vorteilhafte 3-Transistor-SRAM-Speicherzelle zur Verfügung. Versuche mit einem vertikalen bistabilen Transistor BIMOS haben ergeben, daß dieser über lange Zeiträume im Hochstrom- und im Sperrzustand verbleibt, während an seinem Gate G das zweite Potential Masse anliegt. Experimentell nachgewiesen wurden Speicherzeiten von mehr als vier Stunden. Die hysteretische Gatespannungs-Kennlinie (Figur 2) läßt sich ohne Veränderung zyklisch durchfahren.

## Patentansprüche

1. SRAM-Speicherzelle mit folgenden Merkmalen:
- Sie weist einen bistabilen Feldeffekttransistor (BIMOS) auf, dessen erster Kanalanschluß (D) mit einem ersten Potentialanschluß (VCC) verbunden ist,
- der zweite Kanalanschluß (S) des bistabilen Feldeffekttransistors (BIMOS) ist mit einem ersten Widerstand (R1) verbunden, dessen von ihm abgewandter Anschluß mit einem zweiten Potentialanschluß (Masse) verbunden ist,
- das Gate (G) des bistabilen Feldeffekttransistors (BIMOS) ist über ein erstes Schalterelement (T1) mit einer ersten Bitleitung (BL1) verbindbar,
- der zweite Kanalanschluß (S) des bistabilen Feldeffekttransistors (BIMOS) ist über ein zweites Schalterelement (T2) mit einer zweiten Bitleitung (BL2) verbindbar.

2. SRAM-Speicherzelle nach Anspruch 1,
bei der das Gate (G) des bistabilen Feldeffekttransistors (BIMOS) mit einem zweiten Widerstand (R2) verbunden ist, dessen vom Gate abgewandter Anschluß mit einem dritten Potential (V3) verbindbar ist.

3. SRAM-Speicherzelle nach einem der vorstehenden Ansprüche,
bei dem vor einem Lesevorgang die zweite Bitleitung (BL2) auf den Wert des zweiten Potentials (Masse) vorladbar ist.

4. SRAM-Speicherzelle nach einem der vorstehenden Ansprüche,
bei der bei einem Schreibvorgang die erste Bitleitung (BL1) wahlweise eines von zwei Potentialen unterschiedlicher Polarität aufweist.

5. SRAM-Speicherzelle nach Anspruch 4,
bei der die beiden Potentiale unterschiedlicher Polarität den gleichen Betrag wie das erste Potential (VCC) haben.

6. SRAM-Speicherzelle nach einem der vorstehenden Ansprüche,
bei der das erste Schalterelement (T1) ein erster Feldeffekttransistor (T1) ist, dessen Gate mit einer ersten Wortleitung (WL1) verbunden ist.

7. SRAM-Speicherzelle nach einem der vorstehenden Ansprüche,
bei der das zweite Schalterelement (T2) ein zweiter Feldeffekttransistor (T2) ist, dessen Gate mit einer zweiten Wortleitung (WL2) verbunden ist.

8. SRAM-Speicherzelle nach Anspruch 7,
bei der die erste (WL1) identisch mit der zweiten (WL2) Wortleitung ist.

9. SRAM-Speicherzelle nach einem der Ansprüche 1 bis 7,
bei der die erste (BL1) identisch mit der zweiten (BL2) Bitleitung ist.

## Claims

1. SRAM memory cell having the following features:
- it has a bistable field-effect transistor (BIMOS) whose first channel connection (D) is connected to a first potential connection (VCC),
- the second channel connection (S) of the bistable field-effect transistor (BIMOS) is connected to a first resistor (R1) whose connection which is remote therefrom is connected to a second potential connection (earth),
- the gate (G) of the bistable field-effect transistor (BIMOS) can be connected via a first switch element (T1) to a first bit line (BL1),
- the second channel connection (S) of the bistable field-effect transistor (BIMOS) can be connected via a second switch element (T2) to a second bit line (BL2).

2. SRAM memory cell according to Claim 1,
in which the gate (G) of the bistable field-effect transistor (BIMOS) is connected to a second resistor (R2) whose connection which is remote from the gate can be connected to a third potential (V3).

3. SRAM memory cell according to one of the preceding claims, in which the second bit line (BL2) can be precharged to the value of the second potential (earth) prior to a reading operation.

4. SRAM memory cell according to one of the preceding claims, in which, during a writing operation, the first bit line (BL1) has either of two potentials of different polarity.

5. SRAM memory cell according to Claim 4,
in which the two potentials of different polarity have the same magnitude as the first potential (VCC).

6. SRAM memory cell according to one of the preceding claims,
in which the first switch element (T1) is a first field-effect transistor (T1) whose gate is connected to a first word line (WL1).

7. SRAM memory cell according to one of the preceding claims,
in which the second switch element (T2) is a second field-effect transistor (T2) whose gate is connected to a second word line (WL2).

8. SRAM memory cell according to Claim 7,
in which the first word line (WL1) is identical to the second word line (WL2).

9. SRAM memory cell according to one of Claims 1 to 7, in which the first bit line (BL1) is identical to the second bit line (BL2).

## Revendications

1. Cellule de mémoire SRAM ayant les caractéristiques suivantes :
- elle comporte un transistor à effet de champ bistable (BIMOS), dont la première borne de canal (D) est reliée à une première borne de potentiel (VCC),
- la deuxième borne de canal (S) du transistor à effet de champ bistable (BIMOS) est reliée à une première résistance (R1) dont la borne éloignée de ladite borne de canal est reliée à une deuxième borne de potentiel (Masse),
- la grille (G) du transistor à effet de champ bistable (BIMOS) peut être reliée par l'intermédiaire d'un premier élément commutateur (T1) à une première ligne de bit (BL1),
- la deuxième borne de canal (S) du transistor à effet de champ bistable (BIMOS) peut être reliée par l'intermédiaire d'un deuxième élément commutateur (T2) à une deuxième ligne de bit (BL2).

2. Cellule de mémoire SRAM selon la revendication 1, dans laquelle la grille (G) du transistor à effet de champ bistable (BIMOS) est reliée à une deuxième résistance (R2) dont la borne éloignée de la grille peut être reliée à un troisième potentiel (V3).

3. Cellule de mémoire SRAM selon l'une des revendications précédentes, dans laquelle, avant une opération de lecture, la deuxième ligne de bit (BL2) peut être préchargée à la valeur du deuxième potentiel (Masse).

4. Cellule de mémoire SRAM selon l'une des revendications précédentes, dans laquelle, lors d'une opération d'écriture, la première ligne de bit (BL1) a au choix un potentiel parmi deux potentiels de polarité différente.

5. Cellule de mémoire SRAM selon la revendication 4, dans laquelle les deux potentiels de polarité différente ont la même valeur absolue que le premier potentiel (VCC).

6. Cellule de mémoire SRAM selon l'une des revendications précédentes, dans laquelle le premier élément commutateur (T1) est un premier transistor à effet de champ (T1) dont la grille est reliée à une première ligne de mot (WL1).

7. Cellule de mémoire SRAM selon l'une des revendications précédentes, dans laquelle le deuxième élément commutateur (T2) est un deuxième transistor à effet de champ (T2) dont la grille est reliée à une deuxième ligne de mot (WL2).

8. Cellule de mémoire SRAM selon la revendication 7, dans laquelle la première ligne de mot (WL1) est identique à la deuxième ligne de mot (WL2).

9. Cellule de mémoire SRAM selon l'une des revendications 1 à 7, dans laquelle la première ligne de bit (BL1) est identique à la deuxième ligne de bit (BL2).
